(19) Europäisches Patentamt European Patent Office Office européen des brevets

(11) **EP 3 605 123 B1**

(12) **EUROPEAN PATENT SPECIFICATION**

(45) Date of publication and mention of the grant of the patent:
**09.04.2025 Bulletin 2025/15**

(21) Application number: **18775676.2**

(22) Date of filing: **06.02.2018**

(51) International Patent Classification (IPC):
**G01R 31/36** (2020.01)     **H01M 10/48** (2006.01)
**H02J 7/00** (2006.01)     **G01R 31/392** (2019.01)
**G01R 31/389** (2019.01)

(52) Cooperative Patent Classification (CPC):
**G01R 31/392; G01R 31/36; G01R 31/389;**
**H01M 10/48; H02J 7/00;** Y02E 60/10

(86) International application number:
**PCT/JP2018/003902**

(87) International publication number:
**WO 2018/179852 (04.10.2018 Gazette 2018/40)**

(54) **STORAGE BATTERY CONTROL DEVICE AND CONTROL METHOD**

AKKUSTEUERVORRICHTUNG UND STEUERUNGSVERFAHREN

DISPOSITIF DE COMMANDE ET PROCÉDÉ DE COMMANDE DE BATTERIE RECHARGEABLE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.03.2017 JP 2017066632**

(43) Date of publication of application:
**05.02.2020 Bulletin 2020/06**

(73) Proprietor: **Vehicle Energy Japan Inc.**
**Hitachinaka-shi**
**Ibaraki 312-8505 (JP)**

(72) Inventors:
• **KOMATSU Daiki**
**Tokyo 100-8280 (JP)**
• **YAMAUCHI Shin**
**Tokyo 100-8280 (JP)**
• **SAKABE Kei**
**Tokyo 100-8280 (JP)**

• **MATTHEY Fanny**
**Tokyo 100-8280 (JP)**
• **OHKAWA Keiichiro**
**Hitachinaka-shi**
**Ibaraki 312-8503 (JP)**
• **NAKAO Ryohhei**
**Hitachinaka-shi**
**Ibaraki 312-8503 (JP)**

(74) Representative: **MERH-IP Matias Erny Reichl Hoffmann**
**Patentanwälte PartG mbB**
**Paul-Heyse-Straße 29**
**80336 München (DE)**

(56) References cited:
WO-A1-2014/027389     JP-A- 2008 122 165
JP-A- 2014 011 060     JP-A- 2014 059 226
JP-A- 2014 059 226     JP-A- 2015 121 520
JP-A- 2016 070 682     US-A1- 2013 185 007
US-A1- 2015 357 852

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

Technical Field

The present invention relates to a battery control device for estimating the state of charge of a battery.

Background Art

In recent years, attention has been focused on a storage battery capable of effectively using energy in order to deal with global warming. In particular, a battery system such as a storage device for a mobile object or a storage device for system interconnection stabilization is expected to become more popular because the battery system can lower dependency on fossil fuels. In order to derive the performance of these systems, it is necessary to properly realize charging and discharging control or state of charge equalization of each battery using parameters such as a state of charge (hereinafter, abbreviated as SOC) or a state of health (hereinafter, abbreviated as SOH) of and a chargeable and dischargeable maximum current (allowable current) of a battery. In order to realize these, a circuit (cell controller) for battery voltage measurement is attached to each battery, and a battery controller equipped with a central processing unit (CPU) based on information transmitted from these cell controllers performs the calculation or operation.

In particular, for the SOH calculation which is an important index for effectively using a battery until the battery reaches the end of its life, there are two types such as a state of health of resistance (internal resistance) (hereinafter abbreviated as SOHR) and a state of health of capacity (hereinafter referred to as SOHQ), in which battery performances which can be grasped by these two types are different. In the SOHR, since the current resistance can be known, it is possible to grasp output performance by knowing power that the current battery can output. On the other hand, in the SOHQ, since the current full charge capacity can be known, it is possible to grasp capacity performance by knowing electric energy that the current battery can bear.

As a method for calculating the SOHQ, there is a method for calculating SOHQ by estimating a current full charge capacity which is estimated from SOC (hereinafter, abbreviated as SOCv) calculated based on an open circuit voltage (hereinafter, abbreviated as OCV) of two points estimated from a voltage during charging and discharging and a current integration value between the two points and comparing the estimated full charge capacity with an initial full charge capacity of the battery. However, it is difficult to accurately estimate the OCV in a state in which the battery is charged and discharged, and therefore there is a problem in that a true value of the SOHQ cannot be more accurately estimated due to many error factors such as an error of a voltage sensor and an error of a current sensor and a value greatly deviating from the true value is output.

PTL 1 discloses a prior art related to SOHQ calculation. In PTL 1, it is possible to exclude a deviation value of the SOHQ and achieve high accuracy, by combining the SOHQ calculated based on the SOCv and the current integration value with SOHQ estimated based on a total discharge capacity from the start of use of the battery up to the present time. On the other hand, there is a problem in that the SOHQ estimated based on the total discharge capacity cannot cope with deterioration factors which do not depend on an individual difference of the SOHQ or the total discharge capacity of the battery because the relational expression of the SOHQ and the total discharge capacity is derived from a representative characteristic value of the battery. PTL 2 relates to a cell control device that places a limitation on the operation of a cell according to a difference between a combination of a computed first internal resistance and a first full charge capacity of the cell, and the combination of a stored second internal resistance and a second full charge capacity. PTL 3 relates to a battery control device which is provided with map data describing a correspondence relationship between an open-circuit voltage and a state of charge of the battery and outputs different state-of-charge values for the same open-circuit voltage according to an amount of elapsed time. PTL 3 relates to a method including: calculating a first soundness of a battery from an open voltage method charging rate variation calculated from an open voltage obtained on the basis of charging/-discharging currents and a terminal voltage and current integration method charging rate variation obtained from a charging/discharging current integrated value; successively estimating the parameter of the equivalent circuit model of the battery on the basis of the charging/discharging currents and a terminal voltage; estimating second soundness on the basis of any parameter; calculating third soundness as an average value between the first soundness estimation and the second soundness; and defining a weighted average value obtained by weighting the third soundness and the previous soundness with weights corresponding to the scale of a soundness difference between the first soundness estimation and the second soundness as current soundness.

Citation List

Patent Literature

PTL 1: JP 2016-070682 A
PTL 2: WO 2014/027389 A1
PTL 3: US 2015/357852 A1
PTL 4: JP 2014 059226 A

Summary of Invention

Technical Problem

As the SOHQ calculation method, the method for calculating a full charge capacity based on SOCv of two points and a current integration value between the two points has been known, but the accuracy of the SOHQ is lowered due to various error factors such as the OCV estimation error. In addition, the method for improving the accuracy by combining the SOHQ with the SOHQ calculated from the total discharge capacity has been known, but has a problem in that the method can not cope with deterioration factors which do not depend on the individual difference or the total discharge capacity of the battery. Therefore, for the SOHQ calculation, there is a need to improve the accuracy of the SOHQ, and cope with the individual difference of the battery or various deterioration factors of the battery.

Solution to Problem

A battery control device according to the present invention to solve the above issue is a battery control device according to the embodiment defined in claim 1. The dependent claim 2 presents a further embodiment of the invention. The description and drawings also present non-claimed embodiments, aspects, examples, and implementations for the better understanding of the claimed embodiment defined in the claims.

Advantageous Effects of Invention

According to the present invention, it is possible to calculate the SOHQ of the battery with high accuracy, and cope with the individual difference of the battery or various deterioration factors by using the SOHQ threshold value based on a deterioration index SOHR of the internal resistance which is directly estimated from battery information.

Brief Description of Drawings

[FIG. 1] FIG. 1 is a configuration example of a storage battery system.
[FIG. 2] FIG. 2 is a configuration example of an SOCv calculation unit.
[FIG. 3] FIG. 3 is a diagram showing an example of an SOHQ calculation unit based on a correlation between SOHR and SOHQ.
[FIG. 4] FIG. 4 is a diagram showing an example of weighting based on difference between SOHQ based on SOCv and SOHQ based on SOHR.
[FIG. 5] FIG. 5 is a diagram showing an example of a correlation between SOHR and SOHQ.
[FIG. 6] FIG. 6 is a diagram showing an example not covered by the claimed invention of an SOHQ calculation unit corresponding to a use history of a battery.
[FIG. 7] FIG. 7 is a diagram showing an example not covered by the claimed invention of an SOHQ calculation unit corresponding to a sudden change in SOHR.

Description of Embodiments and Examples

Hereinafter, the present invention will be described.

<<First Embodiment>>

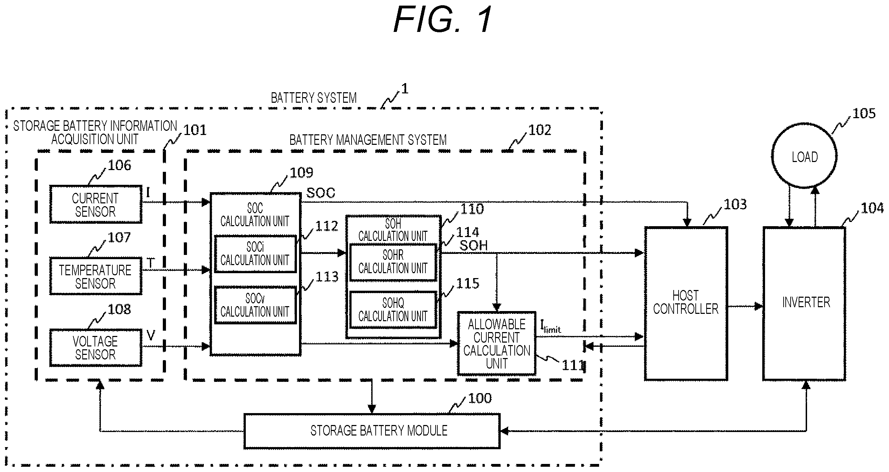

Hereinafter, a first embodiment will be described with reference to FIGS. 1 to 4. FIG. 1 shows a battery system according to the present invention. The battery system is used for a wide range of applications such as a storage device for moving bodies and a storage device for system interconnection stabilization, and is configured to include a battery system 1 which stores power, an inverter 104 which charges and discharges the battery system 1, a load 105 which is connected to the inverter, and a host controller 103 which controls the battery system 1 or the inverter 104.

The battery system 1 calculates control values of a battery such as SOC which is a control value required for power storage and discharge, and SOH allowable current which is a control value necessary for grasping current performance of the battery. The host controller 103 controls the storage battery module 100 according to a state of the load 105, the control value of the battery from which the battery system 1 is output, or other commands from the outside, or issues an input and output command of power to and from the inverter 104. The inverter 104 inputs and outputs power to and from the storage battery module 100 and the load 105 according to the command from host controller 103. The load 105 is, for example, a three-phase alternating current (AC) motor or a power system.

A voltage output from the storage battery module 100 is a direct current (DC) voltage which varies with a state of charge, and in many cases, the storage battery module 100 cannot directly supply power to the load 105 which requires AC. The inverter 104 performs a conversion of DC into an alternating current or a voltage conversion as necessary. With such a configuration, the battery system can appropriately supply an output suitable for a load. Hereinafter, the configuration of the battery system 1 for realizing this configuration will be described.

The battery system 1 is configured to include the storage battery module 100, a storage battery information acquisition unit 101, and a battery management system 102, and charges and discharges power, and calculates control values of a battery such as SOC and an allowable current.

The storage battery module 100 is constituted by a plurality of storage batteries. Each storage battery is connected to the storage battery module 100 in series or in parallel according to an output voltage or capacity required for the storage battery module 100. This series number is determined in consideration of the fact that the output voltage of the storage battery varies with the SOC.

The storage battery information acquisition unit 101 is configured to include a current sensor 106 which measures a value of current flowing in the storage battery, a temperature sensor 107 which measures a surface temperature of the storage battery, and a voltage sensor 108 which measures a voltage of the storage battery.

There are cases in which one or a plurality of current sensors 106 are installed between the storage battery module 100 and the outside. When one current sensor 106 is installed, it is possible to minimize costs. In the case in which the plurality of current sensors 106 are installed, it is possible to grasp a current distribution between the storage batteries connected in parallel.

One voltage sensor 108 is installed in each storage battery. As a result, it becomes possible to measure a voltage difference between the respective storage batteries, and perform an equalization control of the voltage between the respective storage batteries based on the measurement.

One or a plurality of temperature sensors 107 are also installed in order to grasp a temperature difference in the storage battery module 100. When one temperature sensor 107 is installed, it is possible to measure a temperature of a predictable point at which a maximum temperature in the storage battery module 100 is reached at a minimum cost. In the case in which the plurality of temperature sensors 107 are installed, it is possible to perform a control in consideration of the minimum temperature and the maximum temperature by measuring the temperature variation in the storage battery module 100.

The battery management system 102 is configured to mainly include an SOC calculation unit 109, an SOH calculation unit 110, and an allowable current calculation unit 111. The SOC calculation unit 109 is configured to include an SOCi calculation unit 112 which calculates SOC from an integrated current amount and an SOCv calculation unit 113 which calculates the SOC based on OCV estimated from the voltage, current and temperature of the battery. The SOH calculation unit 110 is configured to include an SOHR calculation unit 114 which calculates SOHR, which is a state of health of resistance (internal resistance), based on information from these battery acquisition unit 101 and the SOC, and an SOHQ calculation unit 115 which calculates SOHQ which is a state of health of capacity. The allowable current calculation unit 111 calculates the allowable current, which is the chargeable and dischargeable maximum current, based on the SOH and the battery information. The battery management system 102 outputs to the host controller the SOC or SOH of the battery and the allowable current which are calculated by the SOC calculation unit 109, the SOH calculation unit 110, and the allowable current calculation unit 111. By outputting the information necessary for the control of the storage battery to the host controller 103 in this manner, the host controller 103 can transmit a power output command corresponding to a load to the storage battery in consideration of the state of the storage battery.

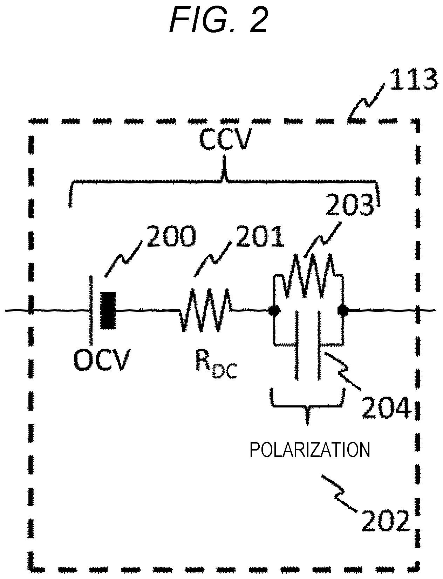

The SOCv calculation unit 113 calculates the SOC by using an equivalent circuit of the storage battery. FIG. 2 shows a configuration of a battery equivalent circuit model used for the calculation. In the battery equivalent circuit model used in the first embodiment, the OCV is represented as a voltage source 200, a direct current resistance representing a resistance of an electrolytic solution and the like is represented as a resistance 201, a resistance component of a polarized portion 202 derived from a concentration polarization or the like of ions in the electrolytic solution is represented as a resistance 203, and a polarized capacity component is a capacitor 204, and a current voltage (closed circuit voltage (hereinafter, abbreviated as CCV)) of a battery is represented by integrating these components. In the first embodiment, one polarization term is used, but a plurality of polarization terms may be used to achieve high accuracy. By using this equivalent circuit model, it is possible to calculate the SOC by estimating the current OCV of the storage battery from each battery information of the current value, the voltage value, and the temperature measured by the above-mentioned storage battery information acquisition unit 101.

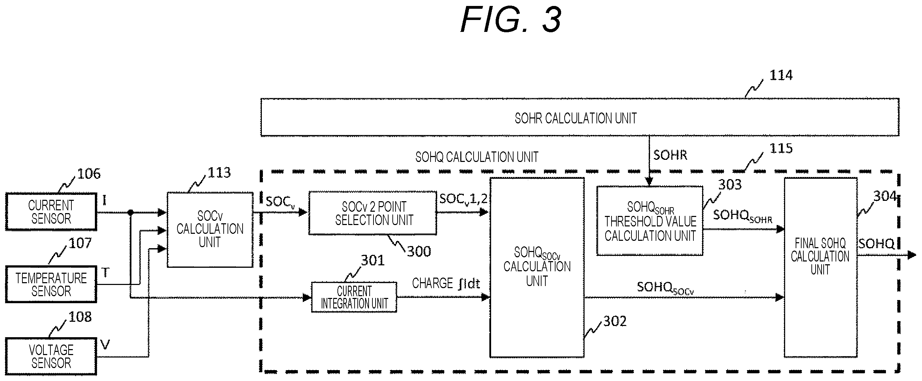

FIG. 3 shows a configuration of the SOHQ calculation unit 115. In the SOHQ calculation unit 115, first, two SOCv1 and SOCv2 suitable for the calculation are selected by an SOCv 2 point calculation unit 300 from the SOCv sequentially output from the SOCv calculation unit 113. As described above, as the SOCv, the SOC is calculated by estimating the OCV by using the equivalent circuit model of the battery. It is important to reduce the error of the equivalent circuit model of the battery and to select a value at which a true value of the SOC and the SOCv approximate each other. In addition, a charge and discharge capacity $\int Idt$ between the SOCv1 and SOCv2 is calculated by an integrated current unit 301 which integrates a value of current flowing between the SOCv1 and SOCv2. The SOHQ (hereinafter, abbreviated as $SOHQ_{SOCv}$) which is directly calculated from the battery information using this SOCv1 and SOCv2 and the $\int Idt$ is calculated by the $SOHQ_{SOCv}$ calculation unit 302. The calculation expression of the $SOHQ_{SOCv}$ is as shown in the following Expression (1).
[Expression 1]

$$SOHQ_{SOCv} = \frac{\int Idt / 3600}{\triangle SOCv / 100} \times \frac{1}{Q\max} \times 100 \qquad \text{(Expression 1)}$$

Qmax is the initial full charge capacity of the battery. Apart from this $SOHQ_{SOCv}$, an $SOHQ_{SOHR}$ threshold value calculation unit 303 calculates, based on a current SOHR value, SOHQ (hereinafter, abbreviated as $SOHQ_{SOHR}$) calculated by the correlation between the SOHR calculated by the SOHR calculation unit 114 and the SOHQ. This correlation may be shown simply by an inverse proportional relation, for example. Generally, since it is known that the relation between the SOHR and the SOHQ is close to this inverse proportional relation, it is possible to easily set the correlation without evaluating the representative battery.

On the other hand, if the correlation between the SOHR and the SOHQ of the representative battery is measured, results obtained by measuring transitions of the SOHR and the SOHQ may be introduced into a correlation expression. Since it is possible to introduce the correlation based on the behavior of the manufactured actual battery instead of the simple inverse proportional expression, the SOHR and the SOHQ may be adopted as long as the representative battery is measured. The SOHQ calculated by a final SOHQ calculation unit 304 using the $SOHQ_{SOCv}$ and $SOHQ_{SOHR}$ is output to the outside.

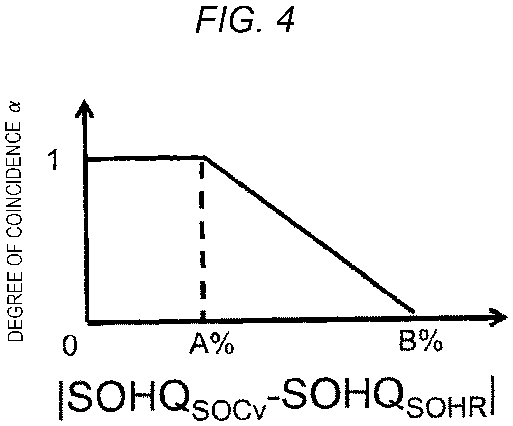

An example of calculation contents performed by the final SOHQ calculation unit 304 is shown. As shown in FIG. 4, a degree of coincidence $\alpha$ between the $SOHQ_{SOCv}$ and the $SOHQ_{SOHR}$ is defined. "A" in FIG. 4 defines the SOHR calculation or the calculation error between the $SOHQ_{SOCv}$ and the $SOHQ_{SOHR}$, and "B" is defined as a value at which the SOHQ can deviate by at most B% from the correlation with the SOHR. Since the $SOHQ_{SOHR}$ is used only for $\alpha$ and therefore is not directly reflected to the final calculation result, the $SOHQ_{SOHR}$ can also handle a deterioration mode deviated from the correlation between the representative batteries of the SOHR and the SOHQ. By performing averaging processing shown by a previous result SOHQ_z (Expression 2) of the SOHQ calculation using the degree of coincidence $\alpha$, the final SOHQ is calculated.
[Expression 2]

$$SOHQ = \frac{\alpha}{N} \times SOHQ_{SOCv} + (1 - \frac{\alpha}{N}) \times SOHQ\_z \qquad \text{(Expression 2)}$$

N is a sampling number of the averaging. Since the SOHQ is not suddenly changed, a previous value of SOHQ and N are used to smooth the calculation value.

With such a configuration, since a range in which the deterioration occurs can be limited by the $SOHQ_{SOHR}$, it is possible to reduce the error factor which was the problem of the $SOHQ_{SOCv}$ and to perform the highly accurate SOHQ calculation.

<<Second Embodiment>>

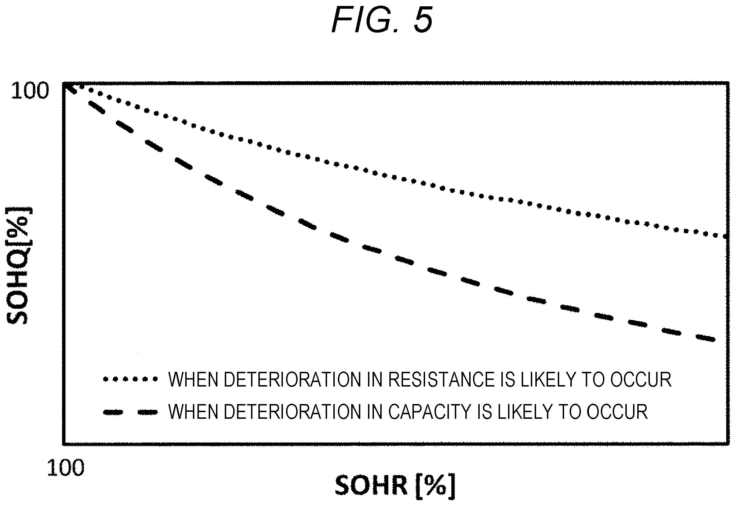

Hereinafter, a second embodiment will be described with reference to FIG. 5. In the first embodiment, a correlation expression between SOHR and SOHQ is considered as one, and averaging processing is performed according to a difference between $SOHQ_{SOHR}$ and $SOHQ_{SOCv}$ calculated from the correlation expression, but there may be plural relational expressions between the SOHR and the SOHQ. The second embodiment shows the correlation determined by intentionally considering a case in which a deterioration in resistance (internal resistance) is more likely to occur than a deterioration in capacity and a case in which the deterioration in capacity is more likely to occur than the deterioration in resistance (internal resistance), from a correlation of a representative battery. Since even SOHR and SOHQ of a battery immediately after shipment is about 100%, the SOHR and the SOHQ do not greatly deviate from the correlation between the SOHR and the SOHQ before the deterioration occurs. However, as the deterioration progresses, the SOHQ and the SOHR greatly deviate from the correlation depending on how to use the battery. If it is possible to have a behavior of the deviation as data in advance, a threshold value as shown in FIG. 5 may be provided, and if this deviation is within two curves, the degree of coincidence $\alpha$ may be set to be 1. Since the SOHQ and the SOHR themselves also have calculation errors as described in the first embodiment, even if this error is taken into consideration and the SOHQ and the SOHR deviate by C% from the curve in FIG. 5, the degree of coincidence $\alpha$ may be set to be 1. By doing so, the threshold value output by the SOHQ threshold value calculation unit can correspond to various deterioration modes, and the deterioration range can be grasped with higher accuracy than in the first embodiment.

<<First example not covered by the invention>>

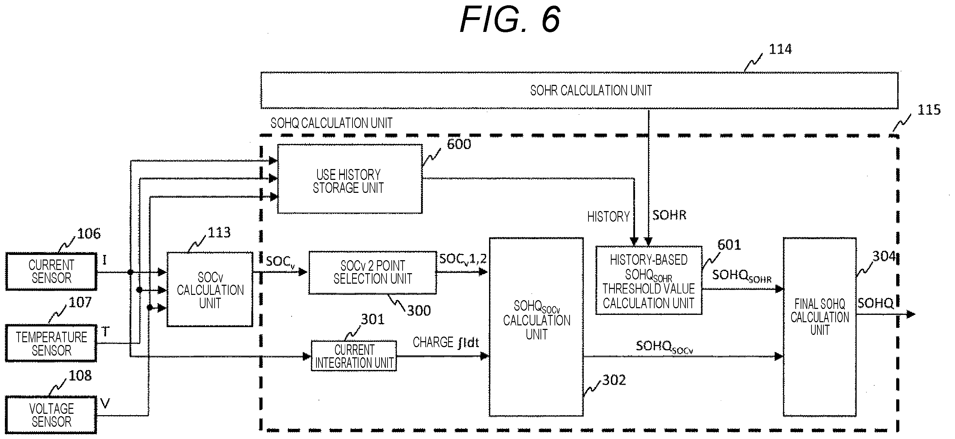

Hereinafter, a first example not covered by the invention will be described with reference to FIG. 6. A threshold for comparing $SOHQ_{SOHR}$ with $SOHQ_{SOCv}$ may be narrowed based on a use history of a battery. This configuration is shown in FIG. 6. The configuration in FIG. 6 is different from that in FIG. 3 in that a use history storage unit 600 which stores a use history such as a use temperature and a charge and discharge frequency of a battery based on current, temperature, and voltage information outputs the history information to a history-based $SOHQ_{SOHR}$ threshold calculation unit 601. As shown in the second embodiment, when a curve is determined in consideration of a plurality of deterioration modes of a battery, a range of the deterioration mode configured by the use history of the battery can be limited. For example, when there is a use history close to that of a battery in which a deterioration in resistance as shown in FIG. 5 is likely to occur, it is possible to limit the range of the deterioration mode to a range close to the curve of the battery in which the deterioration in resistance is likely to occur. In this manner, it is possible to realize the SOHQ calculation with higher accuracy than the second embodiment by dynamically specifying the deterioration range from the history information.

<<Second example no covered by the invention>>

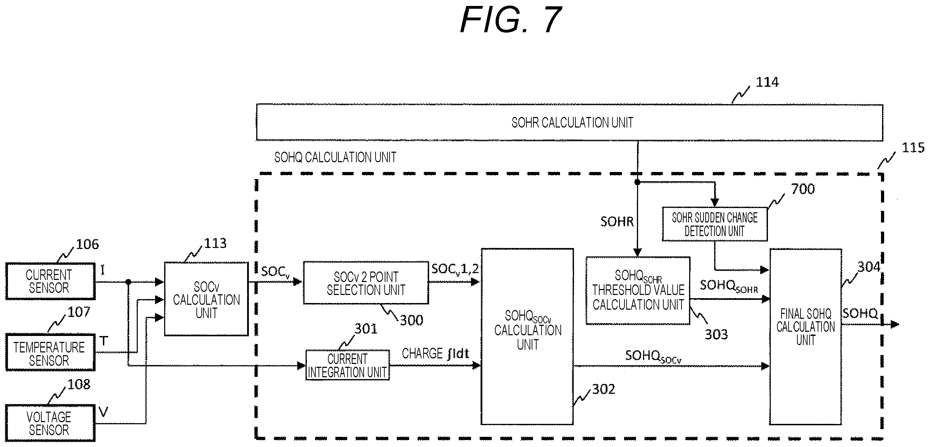

Hereinafter, a second example not covered by the invention will be described with reference to FIG. 7. In the second example, when a calculation value of SOHR is suddenly changed, a configuration in which a result of SOHR is not used for a calculation of SOHQ will be described. This configuration is shown in FIG. 7. A difference from the configuration of the first embodiment is that there is an SOHR sudden change detection unit 700 which successively detects an SOHR calculation value and determines whether or not a sudden change occurs. Since the SOHR is basically not changed suddenly, an output value of an $SOHQ_{SOHR}$ threshold value calculation unit is not suddenly changed. However, for example, when a battery is left unused for a long time, an SOHR calculation value may be suddenly changed due to a long-term storage deterioration. At this time, if an SOHQ threshold value is also suddenly changed by the suddenly changed SOHR calculation value, the SOHQ calculation is not stabilized. Therefore, when an SOHR sudden change detecting unit 701 determines that the SOHR is suddenly changed, $SOHQ_{SOHR}$ is not used and only the result of $SOHQ_{SOCv}$ is used. By doing this, it is possible to perform the calculation without being affected by the sudden change in the SOHR.

Hereinabove, the present invention is briefly summarized.

According to the present invention, a battery control device includes: an SOHQ calculation unit which calculates SOHQ based on a value including a current value and/or a voltage value of a battery; a threshold value determination unit which determines an SOHQ threshold value based on an internal resistance of the battery; and an SOHQ determination unit which determines the SOHQ based on a comparison between the SOHQ calculated by the SOHQ calculation unit and the SOHQ threshold value. With such a configuration, it is possible to cope with the individual difference or various deterioration factors of the battery

In addition, according to the present invention, a method for comparing SOHQ with an SOHQ threshold value varies depending on the internal resistance of the battery. With such a configuration, it is possible to limit the range of the deterioration mode to the range close to the curve of the battery in which the deterioration in resistance is likely to occur when the use history is close to that of the battery in which the deterioration in resistance is likely to occur.

In addition, according to the present invention, the battery control device has the storage unit, and the SOHQ threshold value is determined based on the deterioration characteristics of one or more batteries built in the storage unit in advance.

In addition, according to the present invention, the battery control device determines the SOHQ threshold value based on battery data most similar to a deterioration tendency among the deterioration characteristics of the battery built in the storage unit, by using temperatures up to present time and a use history of the battery. In this manner, it is possible to perform the SOHQ calculation with higher accuracy by dynamically specifying the deterioration range from the history information.

In addition, according to the present invention, the battery control device calculates the final SOHQ only based on the SOHQ calculation unit when the internal resistance is suddenly changed.

Reference Signs List

| | |
|---|---|
| 1 | battery system |
| 100 | storage battery module |
| 101 | storage battery information acquisition unit |
| 102 | battery management system |
| 103 | host controller |
| 104 | inverter |
| 105 | load |
| 106 | current sensor |
| 107 | temperature sensor |
| 108 | voltage sensor |
| 109 | SOC calculation unit |
| 110 | SOH calculation unit |
| 111 | allowable current calculation unit |
| 112 | SOCi calculation unit |
| 113 | SOCv calculation unit |
| 114 | SOHR calculation unit |
| 115 | SOHQ calculation unit |
| 200 | OCV |
| 201 | DC resistance |
| 202 | polarized portion |
| 203 | polarization resistance |
| 204 | polarization capacitor |
| 300 | SOCv 2 point selection unit |
| 301 | current integration unit |
| 302 | $SOHQ_{SOCv}$ calculation unit |
| 303 | $SOHQ_{SOHR}$ threshold value calculation unit |
| 304 | final SOHQ calculation unit |
| 600 | use history storage unit |
| 601 | history-based $SOHQ_{SOHR}$ threshold value calculation unit |
| 700 | SOHR sudden change detection unit |

**Claims**

1. A battery control device connectable to a battery acquisition unit (101) and to a battery (100), the battery control device comprising:

   an SOHR calculation unit (114) configured to calculate an SOHR based on information from the battery acquisition unit (101) and an SOC of the battery;
   an SOHQ calculation unit (302) configured to calculate an SOHQ based on a value including a current value and/or a voltage value of the battery (100); and
   a threshold value determination unit (303) configured to determine an SOHQ threshold value based on an internal resistance of the battery obtained from the calculated SOHR;
   the battery control device being **characterized by** further comprising: an SOHQ determination unit (304) configured to calculate a final SOHQ by performing averaging processing shown by a previous result of the SOHQ calculation using a degree of coincidence, $\alpha$, based on a comparison between the SOHQ calculated by the SOHQ calculation unit (302) and the SOHQ threshold value.

2. The battery control device according to claim 1, wherein the comparison between the SOHQ with the SOHQ threshold value varies with the internal resistance of the battery such that the degree of coincidence, $\alpha$, is set to 1 if the deviation from a correlation of a representative battery, being an inverse proportional relation, is within two curves, the first curve showing when the deterioration in resistance is likely to occur and the second curve showing when the deterioration in capacity is likely to occur.

**Patentansprüche**

1. Batteriesteuervorrichtung, die mit einer Batterieerfassungseinheit (101) und mit einer Batterie (100) verbindbar ist, wobei die Batteriesteuervorrichtung umfasst:

   eine SOHR-Berechnungseinheit (114), die konfiguriert ist, um eine SOHR basierend auf Informationen von der Batterieerfassungseinheit (101) und einem SOC der Batterie zu berechnen;
   eine SOHQ-Berechnungseinheit (302), die konfiguriert ist, um eine SOHQ basierend auf einem Wert, der einen Stromwert und/oder einen Spannungswert der Batterie (100) enthält, zu berechnen; und
   eine Schwellenwertbestimmungseinheit (303), die konfiguriert ist, um einen SOHQ-Schwellenwert basierend auf einem Innenwiderstand der Batterie, der aus der berechneten SOHR erhalten wird, zu bestimmen;
   wobei die Batteriesteuervorrichtung **dadurch gekennzeichnet ist, dass** sie ferner umfasst:
   eine SOHQ-Bestimmungseinheit (304), die konfiguriert ist, um eine endgültige SOHQ durch Durchführen einer Durchschnittsverarbeitung, die durch ein vorheriges Ergebnis der SOHQ-Berechnung gezeigt wird, unter Verwendung eines Koinzidenzgrads $\alpha$ basierend auf einem Vergleich zwischen der SOHQ, die durch die SOHQ-Berechnungseinheit (302) berechnet wird, und dem SOHQ-Schwellenwert zu berechnen.

2. Batteriesteuervorrichtung nach Anspruch 1, wobei der Vergleich zwischen der SOHQ mit dem SOHQ-Schwellenwert mit dem Innenwiderstand der Batterie variiert, so dass der Koinzidenzgrad $\alpha$ auf 1 gesetzt wird, wenn die Abweichung von einer Korrelation einer repräsentativen Batterie, die eine umgekehrt proportionale Beziehung ist, innerhalb von zwei Kurven liegt, wobei die erste Kurve zeigt, wann die Verschlechterung des Widerstands wahrscheinlich auftritt, und die zweite Kurve zeigt, wann die Verschlechterung der Kapazität wahrscheinlich auftritt.

**Revendications**

1. Dispositif de commande de batterie pouvant être connecté à une unité d'acquisition de batterie (101) et à une batterie (100), le dispositif de commande de batterie comprenant :

   une unité de calcul de SOHR (114) configurée pour calculer un SOHR sur la base d'informations provenant de l'unité d'acquisition de batterie (101) et d'un SOC de la batterie ;
   une unité de calcul de SOHQ (302) configurée pour calculer un SOHQ sur la base d'une valeur comprenant une valeur de courant et/ou une valeur de tension de la batterie (100) ; et
   une unité de détermination de valeur de seuil (303) configurée pour déterminer une valeur de seuil de SOHQ sur la base d'une résistance interne de la batterie obtenue à partir du SOHR calculé ;
   le dispositif de commande de batterie étant **caractérisé en ce qu'**il comprend en outre :
   une unité de détermination de SOHQ (304) configurée pour calculer un SOHQ final en effectuant un traitement de moyenne représenté par un résultat précédent du calcul de SOHQ en utilisant un degré de coïncidence, $\alpha$, sur la base d'une comparaison entre le SOHQ calculé par l'unité de calcul de SOHQ (302) et la valeur de seuil de SOHQ.

2. Dispositif de commande de batterie selon la revendication 1, dans lequel la comparaison entre le SOHQ avec la valeur de seuil de SOHQ varie avec la résistance interne de la batterie de sorte que le degré de coïncidence, $\alpha$, est fixé à 1 si l'écart par rapport à une corrélation d'une batterie représentative, qui est une relation proportionnelle inverse, est dans deux courbes, la première courbe montrant quand la détérioration de la résistance est susceptible de se produire et la seconde courbe montrant quand la détérioration de la capacité est susceptible de se produire.

## FIG. 1

# FIG. 2

## FIG. 3

EP 3 605 123 B1

FIG. 4

$|SOHQ_{SOCv} - SOHQ_{SOHR}|$

FIG. 5

EP 3 605 123 B1

EP 3 605 123 B1

## FIG. 6

SOHR CALCULATION UNIT — 114

SOHQ CALCULATION UNIT — 115

USE HISTORY STORAGE UNIT — 600

CURRENT SENSOR — 106

TEMPERATURE SENSOR — 107

VOLTAGE SENSOR — 108

SOCv CALCULATION UNIT — 113

SOCv 2 POINT SELECTION UNIT — 300

CURRENT INTEGRATION UNIT — 301

$SOHQ_{SOCv}$ CALCULATION UNIT — 302

HISTORY-BASED $SOHQ_{SOHR}$ THRESHOLD VALUE CALCULATION UNIT — 601

FINAL SOHQ CALCULATION UNIT — 304

$SOC_v$  $SOC_v1,2$  CHARGE $\int I dt$

HISTORY  SOHR  $SOHQ_{SOHR}$  $SOHQ_{SOCv}$  SOHQ

# FIG. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016070682 A
- WO 2014027389 A1
- US 2015357852 A1
- JP 2014059226 A